# EUROPEAN PATENT SPECIFICATION

(11) **EP 3 932 894 B1**
(45) Date of publication and mention of the grant of the patent: **27.12.2023**
(21) Application number: 20765720.6
(22) Date of filing: 28.02.2020
(51) Int. Cl.: C04B 41/80, C04B 35/622, B28B 11/00, C04B 35/581, C04B 35/587, C04B 35/634, H01L 23/00, H01L 23/12, H05K 1/03, H05K 3/00, B41M 5/26

(54) **CERAMIC GREEN SHEET, METHOD FOR PRODUCING CERAMIC GREEN SHEET AND METHOD FOR PRODUCING CERAMIC SUBSTRATE**
KERAMISCHE GRÜNFOLIE, VERFAHREN ZUR HERSTELLUNG EINER KERAMISCHEN GRÜNFOLIE UND VERFAHREN ZUR HERSTELLUNG EINES KERAMISCHEN SUBSTRATS
FEUILLE DE CÉRAMIQUE CRUE, PROCÉDÉ DE PRODUCTION DE FEUILLE DE CÉRAMIQUE CRUE ET PROCÉDÉ DE PRODUCTION DE SUBSTRAT CÉRAMIQUE

(30) Priority: 01.03.2019 JP 2019037595
(43) Date of publication of application: 05.01.2022
(60) Divisional application: 23161634.3
(73) Proprietor: Denka Company Limited, Tokyo 103-8338 (JP)
(72) Inventor: YUASA Akimasa, Tokyo 103-8338 (JP); KOBASHI Seiji, Tokyo 103-8338 (JP); NISHIMURA Koji, Tokyo 103-8338 (JP)
(74) Representative: Gulde & Partner
(86) International application number: PCT/JP2020/008426
(87) International publication number: WO 2020/179699

(56) References cited:
- EP-A1- 2 315 508
- EP-A1- 3 361 504
- JP-A- 2001 253 763
- JP-A- 2005 210 028
- JP-A- 2005 520 334
- JP-A- 2007 030 378
- JP-A- 2009 135 322

## Description

### TECHNICAL FIELD

The present invention relates to a ceramic green sheet, a method of producing a ceramic green sheet, and a method of producing a ceramic substrate.

### BACKGROUND ART

When a ceramic substrate used for producing an electronic device is produced, an attempt to record useful information relating to production by marking the ceramic substrate with a laser is known.

For example, Patent Document 1 describes that a ceramic compact including, as a discoloring agent, a single substance, an oxide, or a composite oxide of at least one metal selected from the group consisting of Mn, Fe, V, Se, and Cu is fired to obtain a sintered compact, and a specific portion of the obtained sintered compact is heated in another atmosphere to form a marking portion having a different color from that of the other portions.

In another example, a specification, drawings, and the like of Patent Document 2 describes a ceramic sheet including a marker pattern. The marker pattern in Patent Document 2 is a two-dimensional code, and the ceramic sheet may be a material such as Al₂O₃, Si₃N₄, or AlN. Patent Document 3 refers to a thin film ceramic sheet having a thickness of 0.5 mm or less. The information for identifying the sheet is written in an area of 20 % or less of the total sheet area by printing with a laser marker.

### RELATED DOCUMENT

### PATENT DOCUMENT

[Patent Document 1] Japanese Unexamined Patent Publication No. 2001-97786
[Patent Document 2] EP 3 361 504 A1
[Patent Document 3] JP 2001 253763 A

### SUMMARY OF THE INVENTION

### TECHNICAL PROBLEM

The ceramic substrate is typically produced by firing a ceramic green sheet (also simply referred to as "green sheet"; the same shall be applied). In particular, in order to improve the production efficiency of the ceramic substrate, a plurality of ceramic substrates can be obtained through steps including: (1) producing a large green sheet first; (2) firing the green sheet to obtain a fired substance; and (3) dividing and dicing the fired substance.

Recently, for example, as the performance of an electronic device further increases, further improvement in the quality of the ceramic substrate, reduction in quality variation, improvement in yield, and the like have been required.

In particular, when the ceramic substrate is produced through the steps of firing and dicing the green sheet having a large area, for example, (1) to (3), for reduction in quality variation and improvement in yield, it is considered that appropriate quality management or optimization of producing conditions from an initial production stage (that is, a stage of producing the green sheet) is important.

Accordingly, the present inventors conducted a thorough investigation in order to provide a novel method capable of performing appropriate quality management or optimization of producing conditions when a plurality of ceramic substrates are produced from a ceramic green sheet.

### SOLUTION TO PROBLEM

As a result of a thorough investigation, the present inventors completed the present invention provided below and achieved the above-described object.

The present invention is set out in the appended set of claims.

There is provided a ceramic green sheet including a plurality of substrate forming regions,
in which a barcode or a two-dimensional code being a QR code, a Data Matrix code or a PDF417 code is drawn in a portion of the ceramic green sheet, and
the barcode or the two-dimensional code is obtained by encoding one or more of the following information (a) to (d),
   (a) information relating to raw materials used when the ceramic green sheet is produced,
   (b) information relating to molding conditions of the ceramic green sheet,
   (c) information relating to a release agent used when a plurality of the ceramic green sheets are stacked, and
   (d) a serial number.

In addition, the present invention provides the following configurations.

There is provided a method of producing a ceramic green sheet, the method including:
a preparation step of preparing a ceramic green sheet including a plurality of substrate forming regions; and
a drawing step of irradiating a portion of the ceramic green sheet with laser light to draw a barcode or a two-dimensional code being a QR code, a Data Matrix code or a PDF417 code,
in which the barcode or the two-dimensional code is obtained by encoding one or more of the following information (a) to (d),
   (a) information relating to raw materials used when the ceramic green sheet is produced,
   (b) information relating to molding conditions of the ceramic green sheet,
   (c) information relating to a release agent used when a plurality of the ceramic green sheets are stacked, and
   (d) a serial number.

In addition, according to the present invention, there is provided a method of producing a ceramic substrate including a plurality of substrate forming regions, the method including a firing step of firing a ceramic green sheet obtained using the above-described method of producing a ceramic green sheet.

### ADVANTAGEOUS EFFECTS OF INVENTION

The present invention provides a novel method capable of performing appropriate quality management or optimization of producing conditions when a plurality of ceramic substrates are produced from a ceramic green sheet.

### BRIEF DESCRIPTION OF THE DRAWINGS

Fig. 1 (A) is a diagram schematically showing a ceramic green sheet according to an embodiment. Fig. 1 (B) is an enlarged view showing a portion indicated by α in Fig. 1 (A).
Fig. 2 is a diagram schematically showing the ceramic green sheet according to the embodiment that is different from Fig. 1 (A).

### DESCRIPTION OF EMBODIMENTS

Hereinafter, embodiments of the present invention will be described in detail with reference to the drawings.

In all the drawings, the same components are represented by the same reference numerals, and the description thereof will not be repeated.

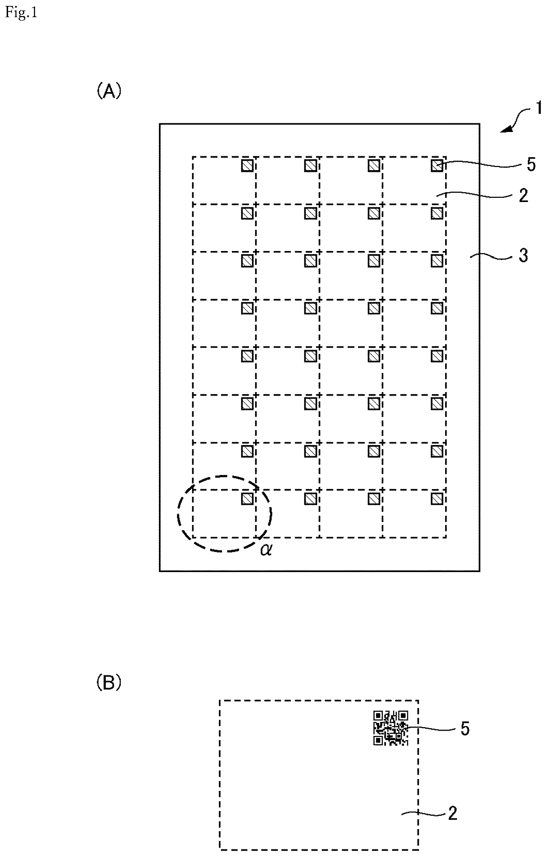

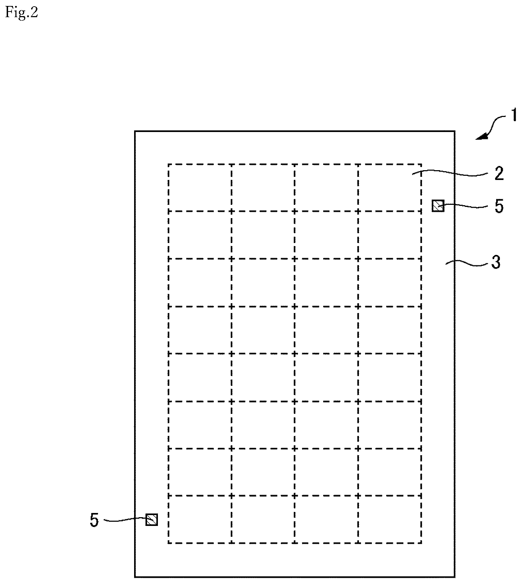

In order to avoid complication, (i) when a plurality of the same components are present on the same drawing, there may be a case where the reference numeral is given to only one component without giving the reference numeral to all the components; and (ii) in the drawings after Fig. 2, there may be a case where the reference numeral is not given again to the same components as those of Fig. 1.

All the drawings are merely illustrative. The shapes, a dimensional ratio, and the like of each of members in the drawings do not necessarily correspond to those of an actual product.

The expression "(meth)acryl" in the present specification represents a concept including acryl and methacryl. The same shall be applied to similar expressions such as "(meth)acrylate".

The expression "electronic device" in the present specification is used as a meaning including an element, a device, a final product and the like to which the electronic engineering technique is applied, for example, a semiconductor chip, a semiconductor element, a printed circuit board, an electrical circuit display apparatus, an information communication terminal, a light emitting diode, a physical cell, or a chemical cell.

The expression "QR code" described in the present specification is a registered tradename.

### <Ceramic Green Sheet (Green Sheet)>

Fig. 1 (A) is a diagram schematically showing a ceramic green sheet 1 (also abbreviated as "green sheet 1") according to an embodiment. In addition, Fig. 1 (B) is an enlarged view showing a portion indicated by α in Fig. 1 (A).

The green sheet 1 includes a plurality of substrate forming regions 2 (rectangular regions indicated by a broken line). Specifically, in the green sheet 1 in Fig. 1 (A), thirty two substrate forming regions 2 in total arranged in eight columns and four rows are present.

The green sheet 1 may include, for example, an outer peripheral region 3 as a region different from the substrate forming regions 2.

A material forming the green sheet 1 is not particularly limited as long as it forms a ceramic substrate by being fired. Specific configurations of the material and the like will be described below.

In a portion of the green sheet 1, a two-dimensional code 5 is drawn. In the green sheet 1 in Fig. 1 (A), the two-dimensional code 5 is drawn in each of the substrate forming regions 2 (also refer to Fig. 1 (B)). Instead of the two-dimensional code 5, a barcode may also be drawn.

Each of the two-dimensional codes 5 (or barcodes) is obtained by encoding one or more of the following information (a) to (d).
(a) Information relating to raw materials used when the ceramic green sheet 1 is produced
(b) Information relating to molding conditions of the ceramic green sheet 1
(c) Information relating to a release agent used when the ceramic green sheets 1 are stacked
(d) A serial number

As described above, for further improvement in the quality of the ceramic substrate as a final product, reduction in quality variation, improvement in yield, and the like, it is considered that appropriate quality management or optimization of producing conditions from an initial producing stage (that is, a stage of producing the green sheet) is important.

By drawing the two-dimensional code 5 or the barcode including one or more of the following information (a) to (d) at a stage "before" obtaining the ceramic substrate by firing as in the green sheet 1, the above-described "appropriate quality management or optimization of producing conditions from an initial producing stage (that is, a stage of producing the green sheet)" can be easily performed.

In other words, the two-dimensional code 5 or the barcode obtained by encoding appropriate information is drawn in the green sheet 1 at a stage before firing, the ceramic substrate can be easily traced "from the beginning to the end" of the production (traceability is improved). Accordingly, more appropriate quality management or optimization of producing conditions can be easily performed through all the producing steps of the ceramic substrate.

The information relating to raw materials of (a) refers to information relating to materials used when the green sheet 1 is produced and the mixing thereof. Specific examples of the information include a compound name of a material used when the green sheet 1 is produced, a trade name of the material, a grade of the material, a particle size of powder in the material, a source of each material, a mixing amount (mixing ratio) of each material, the amount of impurity to be included, and a lot number of a slurry (composition for molding the green sheet) before being molded in a sheet shape. Of course, the information is not limited to these examples.

For example, the two-dimensional code 5 or barcode obtained by encoding the lot number of the slurry before being molded in a sheet shape is drawn in the green sheet 1 such that the lot number of the slurry and a final product (ceramic substrate) can be easily associated with each other. That is, raw material data of the final product and the quality of the final product can be associated with each other one by one, and the quality management and the quality improvement can be easily performed from the viewpoint of raw materials.

Examples of the information relating to molding conditions of (b) include information relating to various molding conditions in " -Preparation Step-molding) described below and a molding lot number (number assigned to one molding step or each of multiple molding steps) . Of course, the information is not limited to these examples.

For example, the two-dimensional code 5 or barcode obtained by encoding the information relating to the molding lot number is drawn in the green sheet 1 such that the molding lot number and a final product (ceramic substrate) can be easily associated with each other. By recording various molding conditions in each molding lot together with the molding lot number, the molding conditions and the quality of the final product can be easily associated with each other. This configuration facilitates the quality management and the quality improvement of the ceramic substrate that is finally obtained.

Examples of the information relating to the release agent of (c) include a composition a release agent (for example, powder having properties that are hardly reactive with the green sheet) used for facilitating to release the substrate obtained after firing in "Stacking of Green sheet" described below, the amount of the release agent used, and a lot number of the release agent. Of course, the information is not limited to these examples.

For example, the two-dimensional code 5 or barcode obtained by encoding the lot number of the release agent to be used or used is drawn in the green sheet 1 such that the lot number of the release agent and a final product (ceramic substrate) can be easily associated with each other. That is, data of the release agent used and the quality of the final product can be associated with each other one by one, and the quality management and the quality improvement of the ceramic substrate that is finally obtained can be easily performed.

The serial number of (d) refers to a number that varies depending on each of the green sheets 1 or a number that varies depending on each of the substrate forming regions 2.

A specific aspect and the like of the green sheet 1 will be continuously described.

### (Aspect of Barcode or Two-Dimensional Code 5)

From the viewpoint of a large amount of information, it is preferable that the two-dimensional code is drawn in the green sheet instead of the barcode. Of course, the barcode may be sufficient depending on the amount of information.

From the viewpoint of versatility, readability, and the like, it is preferable that the two-dimensional code 5 is a QR code. Of course, the two-dimensional code 5 is not limited to only the QR code and may be a Data Matrix code or a PDF417 code as well.

The size of the barcode or the two-dimensional code 5 is not particularly limited as long as it is readable by a reading device that can be typically used. Typically, the size is within a range of about 1 mm × 1 mm to 5 mm × 5 mm. By adopting the appropriate size, sufficient readability can be obtained while adjusting the space.

In one aspect, in the portion of the green sheet 1 where the barcode or the two-dimensional code 5 is drawn, a recess portion corresponding to a line of the barcode or a cell of the two-dimensional code 5 is present (aspect 1). The depth of the recess portion is preferably 10 pm or more and 100 pm or less and preferably 12 pm or more and 80 um or less.

By forming the barcode or the two-dimensional code 5 using physical unevenness, the readability of the barcode or the two-dimensional code can be further improved. In addition, there is an effect in that, for example, even when the color of the ceramic substrate obtained by firing the green sheet 1 changes, the readability of the barcode or the two-dimensional code can be easily sufficiently obtained (in particular, when the depth of the recess portion is 10 um or more, this effect is high).

In another aspect, the color of the portion forming the barcode or the two-dimensional code 5 is different from that of the other portions of the green sheet 1 (aspect 2). For example, the cell portion forming the barcode or the two-dimensional code 5 is blackened.

In the embodiment, for example, the green sheet 1 includes a binder resin such that, when irradiated with laser light, the binder resin can be carbonized to blacken the cell portion.

It is preferable that the barcode or the two-dimensional code 5 has the characteristics of both of the aspect 1 and the aspect 2. By having the characteristics of both of the aspect 1 and the aspect 2, the readability can be further improved irrespective of before and after firing.

The barcode or the two-dimensional code 5 can be drawn typically with a laser. Specific features relating to the laser will be described below.

### (Position, Number, and the Like of Barcodes or Two-Dimensional Codes 5)

In one aspect, it is preferable that the barcodes or the two-dimensional codes 5 are drawn in two or more of the plurality of substrate forming regions 2, respectively, instead of one substrate forming region 2. In addition, it is preferable that the two or more barcodes or the two or more two-dimensional codes are obtained by encoding different pieces of information.

By providing the two or more barcodes or the two or more two-dimensional codes 5 instead of providing only one barcode or two-dimensional code 5 in one green sheet 1, each of the final ceramic substrates obtained by firing and dividing (dicing) the green sheet 1 can be associated with the green sheet 1. That is, the traceability of all the producing steps of ceramic substrate can be further improved.

In addition, the two or more barcodes or the two or more two-dimensional codes are obtained by encoding different pieces of information (for example, different serial numbers). As a result, for example, "position where the green sheet 1 is placed in a furnace" during firing and the quality of the final ceramic substrate can be associated with each other. The quality of the ceramic substrate may vary depending on small firing conditions. Accordingly, by establishing this association, the quality management or the optimization of the producing conditions can be more appropriately performed.

In particular, by drawing the barcodes or the two-dimensional codes 5 in all the plurality of substrate forming regions 2, respectively, and further recording different information in all the barcodes or the two-dimensional codes 5, the above-described effect of further improving the traceability can be more significantly obtained.

On the other hand, in another aspect, as shown in Fig. 2, the barcode or the two-dimensional code may be drawn in, for example, the outer peripheral region 3 that is a region different from the substrate forming regions 2.

In this case, the barcode or the two-dimensional code 5 is not drawn in the substrate forming regions. Therefore, the green sheet 1 can be associated with the final ceramic substrate obtained by firing and dicing the green sheet 1. However, of course, the green sheet 1 can be associated with the ceramic substrate (including a plurality of substrate forming regions) obtained by firing the green sheet 1.

The aspect of Fig. 2 has an advantageous effect in that the barcode or the two-dimensional code 5 that is "unnecessary as a product" is not provided in the portion of the substrate forming region 2 as a final product. For example, when it is important to form a circuit "without a gap" or to connect an element to the final ceramic substrate, it is preferable that the barcode or the two-dimensional code is drawn as in Fig. 2 instead of Fig. 1.

### (Various Sizes and the Like)

The size of the green sheet 1 is not particularly limited. From the viewpoints of simultaneously improving mass productivity and handleability, the size of the green sheet 1 is about 100 cm × 150 cm to 250 cm × 350 cm.

Although varies depending on the size of the ceramic substrate that is finally obtained, the size of each of the substrate forming regions 2 is, for example, about 75 cm × 115 cm to 190 cm × 270 cm.

From the viewpoint of mass productivity or the like, it is preferable that the single green sheet 1 includes two to two hundred substrate forming regions 2.

### (Material/Producing Method of Green sheet)

The green sheet 1 can be produced through a series of steps including: a preparation step of preparing a green sheet including a plurality of substrate forming regions; and a drawing step of irradiating a portion of the green sheet with laser light to draw a barcode or a two-dimensional code being a QR code, a Data Matrix code or a PDF417 code. Here, the drawn barcode or the two-dimensional code is obtained by encoding one or more of the above-described information (a) to (d) .

Specifically, the above-described "preparation step" may include steps including "Preparation and Mixing of Material", "Molding", and the like.

Hereinafter, these steps and "drawing step" will be described.

### ·Preparation Step-Preparation and Mixing of Material

Typically, the green sheet can be produced by molding a mixture (the mixture is, for example, in the form of a slurry) including powder of an inorganic compound such as a nitride, an oxide, or a carbide, a binder resin, a sintering additive, a plasticizer, a dispersant, a solvent, and the like.

Examples of the inorganic compound include silicon nitride (Si₃N₄), aluminum nitride (AlN), silicon carbide, and aluminum oxide. Among these, silicon nitride and aluminum nitride are preferable.

From the viewpoint of uniformity or the like of the components in the green sheet, it is preferable that the average particle size of the powder of the inorganic compound is 5 um or less.

Examples of the sintering additive include a rare earth metal, an alkali earth metal, a metal oxide, a fluoride, a chloride, a nitrate, and a sulfate. Among these, only one kind may be used, two or more kinds may be used in combination. By using the sintering additive, the sintering of the inorganic compound powder can be promoted.

From the viewpoint of appropriately promoting the sintering, the amount of the sintering additive used is preferably 1 part by mass or more 15 parts by mass or less from the viewpoint 100 parts by mass of the powder of the inorganic compound.

Specific preferable examples of the sintering additive include yttrium oxide (Y₂O₃), magnesium oxide (MgO), and aluminum oxide (Al₂O₃).

The binder resin may be any one as long as it improves insufficient moldability only with the powder of the inorganic compound or the like. In the embodiment, it is preferable that the binder resin is blackened (carbonized) to improve the contrast of the barcode or the two-dimensional code when irradiated with a laser. From this viewpoint, the binder resin is typically an organic resin binder . The organic resin binder may be powdery or liquid at a typical temperature.

For example, it is preferable that the binder resin is at least one of methyl cellulose, ethyl cellulose, polyvinyl alcohol, polyvinyl butyral, or a (meth)acrylic resin.

The amount of the binder resin is preferably 0.5 to 30 parts by mass with respect to 100 parts by mass of the powder of the inorganic compound.

By using an appropriately large amount of the binder resin, the slurry can be easily molded in a sheet shape, and a sufficient compact strength can be easily obtained. Further, blackening (carbonization) by laser irradiation can be sufficiently obtained, which contributes to the improvement of the contrast of the barcode or the two-dimensional code. On the other hand, by appropriately adjusting the amount of the binder resin, there is a tendency that the time of a degreasing process can be reduced.

As the plasticizer, a phthalic acid plasticizer such as refined glycerin, glycerin trioleate, diethylene glycol, or di-n-butyl phthalate, or a dibasic acid plasticizer such as di-2-ethylhexyl sebacate can be used.

When the plasticizer is used, the amount of the plasticizer is preferably 0.1 to 10 parts by mass with respect to 100 parts by mass of the powder of the inorganic compound. By using an appropriately large amount of the plasticizer, there is a tendency that cracking can be easily suppressed during molding in the green sheet. On the other hand, by using an appropriately small amount of the plasticizer, the shape of the green sheet can be easily retained.

The dispersant is not particularly limited, and examples thereof include poly(meth) acrylic acid and a (meth)acrylic acid-maleate copolymer.

Examples of the solvent include an organic solvent such as ethanol or toluene. On the other hand, in consideration of a global environment or explosion-proof facilities, water (for example, ion exchange water or pure water) can also be used.

The amount of the solvent used is preferably 1 to 60 parts by mass with respect to 100 parts by mass of the powder of the inorganic compound. By using an appropriate amount of the solvent, appropriate fluidity during formation of the green sheet and shape retention of the green sheet can be improved simultaneously.

For example, (1) first, the powder of the inorganic compound and the sintering additive among the above-described components are mixed with each other, and (2) the mixture is mixed with the other components such as the binder resin, the plasticizer, or the organic solvent. As a result, a slurry for molding the green sheet can be obtained.

Here, the mixing can be performed using, for example, a ball mill.

Incidentally, it is preferable that materials forming the green sheet 1 does not include a discoloring agent in addition to the above-described materials where the color changes depending on irradiation of laser light. In addition, even when the discoloring agent is included, the proportion thereof is preferably 0.03 mass% or lower with respect to all the solid components forming the green sheet 1. For example, it is preferable that the green sheet 1 does not include the discoloring agent described in Patent Document 1 that is the single substance, the oxide, or the composite oxide of at least one metal selected from the group consisting of Mn, Fe, V, Se, and Cu, and even if the discoloring agent is included, it is preferable that the amount thereof is in the above-described range. The reason for this is that the above-described discoloring agent (particularly including a metal element) may have an unintended effect on the performance and the like of the final ceramic substrate.

### ·Preparation Step-Molding

The slurry obtained as described above is molded to form a green sheet. As the molding method, for example, a doctor blade method can be used. That is, a layer of the slurry cast from a gap that can be adjusted by a doctor blade (blade) is provided on a surface of a film or a sheet that travels in one direction. As a result, the green sheet can be formed.

In addition, molding may be performed using an extrusion molding method. Specifically, the slurry that are adjusted to have viscosity and fluidity for extrusion molding may be extruded using an appropriate device to form the green sheet.

The thickness of the green sheet may be appropriately set in consideration of the thickness of the ceramic substrate that is finally obtained, shrinkage by firing, and the like. The thickness is typically 0.25 mm or more and 1.4 mm or less, preferably 0.25 mm or more and 0.9 mm or less, and more preferably 0.25 mm or more and 0.8 mm or less.

During molding, an appropriate drying process may be performed on the green sheet. In particular, when the slurry includes an organic solvent, it is preferable that the amount of the organic solvent remaining in the green sheet is reduced by performing the drying process.

The green sheet that is formed using the doctor blade method typically has an elongated strip shape. Accordingly, the green sheen is punched or divided in a predetermined shape and size. The punching and dividing can be performed, for example, a press cutting machine.

### ·Drawing step (Irradiation of Laser Light)

The green sheet molded as described above can be irradiated with laser light to draw the barcode or the two-dimensional code. Due to the energy of the laser light, the portion irradiated with the laser light can be formed in a recessed shape or discolored as described above.

As a result, for example, as shown in Fig. 1 (A), the green sheet 1 where the two-dimensional codes 5 (or the barcodes) are drawn and a plurality of substrate forming regions 2 are provided can be produced.

The wavelength of the laser light is not particularly limited as long as the two-dimensional codes 5 or the barcode scan be drawn on the green sheet 1. In the embodiment, for example, an infrared laser, specifically, an infrared laser having a wavelength of 1064 nm or 1070 nm can be used. In addition, in another example, a visible light laser, specifically a visible light laser having a wavelength of 532 nm, and an ultraviolet laser, specifically an ultraviolet laser having a wavelength of 355 nm can also be used.

From the practical viewpoint, a commercially available laser marker or the like can be used as the laser.

The scanning speed of the laser light is not particularly limited. From the viewpoints of drawing the two-dimensional code 5 or the barcode having sufficient readability and obtaining productivity (speed) simultaneously, the scanning speed of the laser light is about 500 mm/s to 4000 mm/s.

The output of the laser light is, for example, about 1 W to 30 W although depending on the materials forming the green sheet 1 and the like.

When the laser is a pulsed laser, the frequency may be 30 kHz to 100 kHz and preferably 40 kHz to 60 kHz.

### <Ceramic Substrate and Method of Producing the Same>

By firing the green sheet according to the embodiment (for example, as in the green sheet 1, the green sheet where a plurality of substrate forming regions are provided and the barcodes or the two-dimensional codes are drawn) to obtain a fired substance, the ceramic substrate including the plurality of substrate forming regions can be produced. This substrate may be expressed as "multi-piece substrate" or the like.

In addition, ceramic substrates that are diced through a dividing step of dividing the ceramic substrate including the plurality of substrate forming regions to obtain a plurality of ceramic substrates can be obtained.

For example, by firing the green sheet through a series of steps including "Stacking of Green sheets", "Degreasing", and "Sintering", the ceramic substrate including the plurality of substrate forming regions can be produced. In addition, by dividing the ceramic substrate including the plurality of substrate forming regions through the dividing step described below, the plurality of ceramic substrates can be produced.

### ·Stacking of Green Sheets

In order to efficiently mass-produce the ceramic substrates, it is preferable that a plurality of green sheets are stacked (overlap) to obtain a stacked body. In order to facilitate separation after firing, it is preferable that a release layer formed of a release agent is provided between the green sheets.

The thickness of the release layer is not particularly limited and is typically about 1 um to 20 um.

As powder for providing the release layer, typically, powder of boron nitride (BN) or a slurry thereof can be used. The average particle size of the powder is preferably 1 pm or more and 20 pm or less.

The release layer can be formed, for example, by applying the slurry of the powder of boron nitride using a method such as spraying, brushing, roll coating, or screen printing.

From the viewpoint of efficiently producing the ceramic substrates while sufficiently performing degreasing described below, the number of the green sheets to be stacked is preferably 8 or more and 100 or less and more preferably 30 or more and 70 or less.

### ·Degreasing (Removal of Organic Material such as Binder Resin)

The green sheet includes an organic material such as a binder resin or a plasticizer. When the green sheet is fired as it is, the amount of carbon remaining in the final ceramic substrate increases, and the performance of the ceramic substrate deteriorates. Accordingly, it is preferable that, before firing described below, the stacked body is heated at an appropriate temperature for "degreasing" (removing the organic material).

The degreasing is performed, for example, at a temperature of 400°C or higher and 800°C or lower for 0.5 hours to 20 hours. By adopting the appropriate temperature and time, the remaining amount of carbon can be reduced, and oxidation and deterioration of the inorganic compound can be suppressed.

### ·Sintering

The green sheets that are stacked and degreased as described above are typically heated at about 1700°C to 1900°C to be sintered such that the ceramic substrates can be obtained.

Here, it is preferable that heating is performed in a non-oxidizing gas atmosphere such as nitrogen, argon, ammonia, or hydrogen.

Here, heating may be performed after putting the green sheet (or the stacked body) into an appropriate container. For example, when a nitride ceramic substrate is produced, it is preferable that heating is performed after putting the green sheet (or the stacked body) into a container formed of boron nitride, graphite, silicon nitride, or the like.

Here, heating may be performed while being pressurized. The pressure during pressurization is, for example, 0.50 MPa to 0.97 MPa.

In the embodiment, the barcode or the two-dimensional code that is drawn at the stage of the green sheet can be sufficiently recognized even after the above-described steps. Accordingly, the effect of improving the traceability through all the producing steps of ceramic substrate can be further obtained.

In particular, by forming the barcode or the two-dimensional code 5 using physical unevenness, there is a tendency that sufficient readability can be easily obtained even after firing.

Incidentally, the entire ceramic substrate and the substrate forming regions shrink due to degreasing, sintering, or the like. When the above-described materials are used, "Dimension of Green sheet ÷ Dimension of Ceramic Substrate" is, for example, about 1.1 to 1.4. It is preferable that the green sheet is produced to be slightly large conversely based on the dimension of the substrate forming regions that are finally obtained (the dimension of the ceramic substrate).

### ·Dividing Step (Dicing)

By dividing the ceramic substrate where the plurality of substrate forming regions are provided and the barcodes or the two-dimensional codes are drawn, a plurality of ceramic substrates that are diced can be produced.

A dividing method is not particularly limited. For example, when a division groove is provided in the ceramic substrate, ceramic substrates that are diced by applying a force to the division groove portion can be obtained.

Alternatively, dicing may be performed by applying a bending stress to the ceramic substrate.

Alternatively, division may be performed using a cutting machine such as a dicing saw (rotary blade).

In addition, the dividing step may be performed using a laser. Specifically, application of a technique such as laser scribing that is known as a processing technique or the like of a semiconductor substrate is considered. As the laser described herein, a carbon dioxide laser, a YAG laser, or the like is preferable, and a carbon dioxide laser having a pulse frequency of 1 kHz or higher and an output of about 50 W to 500 W is more preferable.

When the dividing step is performed using a laser, the ceramic substrate may be diced using only a laser, or the ceramic substrate may be diced using a combination of a laser and another method. Based on the findings of the present inventors, the latter case is more preferable from the viewpoint that the formation of fine cracks can be further reduced. Of course, the ceramic substrate may be diced using only a laser as long as diced ceramic substrates having a sufficient quality can be obtained.

In a specific example of the latter case, first, a scribe line is provided around the substrate forming regions to be diced in the ceramic substrate using a laser. Here, the scribe line is formed of, for example, a plurality of recess portions that are formed to line in a line on the ceramic substrate (each of the recess portions is formed by laser irradiation) . In another example, the scribe line has a groove shape that extends in a specific direction. The scribe line can refer to the description in Japanese Unexamined Patent Publication No. 2007-324301, Japanese Unexamined Patent Publication No. 2013-175667, Japanese Unexamined Patent Publication No. 2014-42066, and the like.

After providing the scribe line in the ceramic substrate, a force is applied manually or mechanically to the ceramic substrate where the scribe line is provided. As a result, the ceramic substrate is divided at the position of the scribe line.

When a laser is used, it is preferable that assist gas is also used in combination. That is, by irradiating the substrate with laser light while spraying assist gas from the vicinity of a laser light source, the effect of improving efficiency or suppressing the occurrence of an unintended decomposition product or precipitate may be obtained.

From the viewpoint of improving the efficiency, an oxidizing gas such as oxygen or air is preferable as the assist gas.

From the viewpoint of, for example, preventing dust from scattering while obtaining the sufficient effect by the assist gas, the amount of the assist gas sprayed is preferably 0.1 m³/min or higher and 1.0 m³/min or lower.

The laser processing (laser scribing) using the assist gas can refer to the description in, for example, Japanese Unexamined Patent Publication No. 2004-181515.

During the division, all the substrate forming regions do not need to be completely diced. For example, by dividing the ceramic substrate in units of four substrate forming regions of 2 × 2, "four-piece substrate" may be obtained.

### ·Other Steps

For example, formation of a metal circuit, connection of an electronic element, or the like may be performed between "sintering" and "dividing step" described above, after "dividing step" described above, or between a step of providing the scribe line using a laser in "dividing step" and the next dividing step. As a method of performing each of the above-described steps, a well-known method can be appropriately applied.

The above-described respective steps, raw materials, and materials can refer to the description in, for example, Japanese Unexamined Patent Publication No. 2018-70436 and Japanese Patent No. 6399252.

Hereinafter, the embodiment of the present invention has been described. However, the embodiment is merely an example of the present invention, and various configurations other than the above-described configurations can be adopted. In addition, the present invention is not limited to the above-described embodiments, and modifications, improvements, and the like within a range where the object of the present invention can be achieved are included in the present invention.

### [Examples]

The embodiments of the present invention will be described in more detail based on Examples and Comparative Examples. The present invention is not limited to Examples.

### <Production of Green Sheet and Production of Ceramic Substrate>

### 1. Preparation of Slurry for Producing Green Sheet

First, the following "inorganic mixture 1", "inorganic mixture 2", and "inorganic mixture 3" were prepared.
·Inorganic Mixture 1
   Silicon nitride: 91.3 mass%
   Y₂O₃: 6.0 mass%
   MgO: 1.6 mass%
   SiO₂: 1.1 mass%
·Inorganic Mixture 2
   Silicon nitride: 95.2 mass%
   Y₂O₃: 3.3 mass%
   MgO: 1.5 mass%
·Inorganic Mixture 3
   Aluminum nitride: 94.2 mass%
   Y₂O₃: 4.0 mass%
   Al₂O₃: 1.8 mass%

In the above description, the details of the respective components are as follows.
Silicon nitride: produced by Denka Co., Ltd., product number: SN-9FWS
Aluminum nitride: produced by Denka Co., Ltd., product number: SR-7
Y₂O₃: produced by Shin-Etsu Chemical Co., Ltd., product number: UU
MgO: produced by Iwatani Chemical Industry Co., Ltd., product number: MJ-30
SiO₂: produced by Denka Co., Ltd., product number: SFP-330MC
Al₂O₃: produced by Taimei Chemicals Co., Ltd., product number: TM-5D

Next, a binder, a plasticizer, a dispersant, and a solvent described above are added to a ball mill with respect to 100 parts by mass of the inorganic mixture 1, 2, or 3 and were mixed with each other for 48 hours to obtain a silicon nitride slurry. As balls in the ball mill, φ25 mm balls formed of silicon nitride were used.

Binder: 18.1 parts by mass of polyvinyl alcohol
Dispersant: 0.4 parts by mass of sorbitan fatty acid ester
Plasticizer: 9.1 parts by mass of triethylene glycol
Solvent: 20.2 parts by mass of toluene
20. 2 parts by mass of methyl ethyl ketone (MEK)
6.7 parts by mass of methanol
6.7 parts by mass of acetone

### 2. Molding of Green Sheet

Molding was performed using a doctor blade method.

Specifically, the silicon nitride slurry obtained as described above was cast at a casting speed of 0.5 m/min, was appropriately dried, and was punched with a die. As a result, a green sheet of 177 mm × 245 mm × 0.44 mm t was obtained (the size after firing was 136.2 mm × 188.5 mm).

Here, the number of substrate forming regions (partitions) in the single green sheet is 4 rows × 8 columns = 32 as shown in Fig. 1, and the size of one substrate forming region is 40.3 mm × 28.6 mm. In addition, an outer peripheral region (non-substrate forming region) is provided in the outer periphery of the substrate forming regions.

### 3. Drawing of Two-Dimensional Code

Using a laser marker, a QR code of 16 cells × 16 cells having a size of 100 to 250 um (shown in Table 1) per cell was drawn in each of all the plurality of substrate forming regions of the green sheet obtained by molding as described above.

Information recorded in the QR code included at least (d) a serial number. The serial number is a consecutive serial number initiating with 1. That is, QR codes obtained by encoding consecutive numbers of 1, 2, 3, ... were sequentially drawn for the thirty two substrate forming regions. In addition, in Examples 12 to 15, not only the serial number but also the information relating to (a) to (c) were also included in the information recorded in the QR codes (the details refer to Table 1).

As the laser marker, in Examples 1 to 17 and 20, among "MD-X series" (produced by Keyence Corporation), a laser marker adopting an infrared laser having a wavelength of 1064 nm and a maximum output of 25 W was used. Various conditions such as a scanning speed were adopted as shown in Table 1.

On the other hand, in Examples 18 and 19, among "MD-U series" (produced by Keyence Corporation), a laser marker adopting an ultraviolet laser having a wavelength of 355 nm and a maximum output of 2.5 W was used. In addition, in Example 19, among "MD-X series" (produced by Keyence Corporation), a laser marker adopting a visible light laser having a wavelength of 532 nm and a maximum output of 4 W was used.

In the portion where the QR code was drawn, recess portions corresponding to the cells of the QR code were formed. In addition, blackening that was presumed to be caused by a chemical change (for example, carbonization) of the binder resin in the green sheet occurred.

### 4. Stacking of Green Sheets, Degreasing, Firing, and the like

A ceramic substrate (sintered compact) including a plurality of substrate forming regions was obtained according to the following procedure.
(1) First, boron nitride powder was deposited on a surface of the green sheet opposite to the surface where the two-dimensional code was printed.
(2) Sixty green sheets where the boron nitride powder was deposited in (1) were stacked on a setter (produced by Denka Co., Ltd., NB1000) for ceramic firing formed of porous boron nitride.
(3) The stacked body obtained in (2) was held at 530°C for 15 hours under a load of 80 kg for degreasing while introducing air. As a result, degreasing was performed.
(4) After degreasing, the load for degreasing was removed, and 1.5 kg of a tungsten weight was placed instead. This stacked body was put into a firing container formed of porous boron nitride and was fired at 1800°C and 0.88 MPa for 5 hours.

### 5. Dicing (Dividing)

Referring to conditions described in Examples (for example, paragraph 0018) of Japanese Unexamined Patent Publication No. 2004-181515, a scribe line (division groove) was provided with a CO₂ laser in the ceramic substrate obtained in 4 described above.

Next, by manually bending the ceramic substrate, the ceramic substrate was divided along the scribe line. As a result, diced ceramic substrates were obtained.

### <Evaluation: Processing Depth>

(i) In the QR code drawn in the green sheet and (ii) the QR code on the ceramic substrate obtained by firing and dicing the green sheet, the maximum depth of recess portions corresponding to the cells of the QR code was measured. The measurement was measured using a 3D measurement system VR-3000 (produced by Keyence Corporation).

### <Evaluation: Readability>

(i) The QR code drawn in the green sheet and (ii) the QR code on the ceramic substrate obtained by firing and dicing the green sheet were read using a code reader SR-2000 (produced by Keyence Corporation) under conditions of a reading distance of 100 mm and 3,100,000 pixels (2048 × 1536 pixels) . The evaluation was performed based on the following two indices.

### (1) Reading Success Rate

When one QR code was read ten times, the number of times the QR code was able to be read was evaluated.

### (2) Matching Level Evaluation

"Matching level" (index representing the margin of reading) defined by Keyence Corporation was obtained. A high numerical value of the matching level represents that accurate reading can be performed with a small error.

The evaluation results and the like are collectively shown in the following table.

### [Table 1]

**[Table 1]**

| | Inorganic Mixture Used | Laser | | | | | | Drawing Information (a) | Drawing Information (b) | Drawing Information (c) | Drawing Information (d) | Green Sheet Evaluation | | | Sintered Compact Evaluation | | |
|---|---|---|---|---|---|---|---|---|---|---|---|---|---|---|---|---|---|
| | | Wave -length nm | Scanning Speed mm/min | Output A | Frequency kHz | Print Cell Size µm | Number of Cells Pixels | | | | | Depth µm | Reading Success Rate | Matching Rate % | Depth µm | Reading Success Rate | Matching Rate % |
| Example 1 | Inorganic Mixture 1 | 1064 | 2000 | 25 | 40 | 200 | 16 × 16 | | | | Included | 40 | 10/10 | 89 | 31 | 10/10 | 85 |
| Example 2 | Inorganic Mixture 1 | 1064 | 2000 | 20 | 40 | 200 | 16 × 16 | | | | Included | 35 | 10/10 | 90 | 27 | 10/10 | 88 |
| Example 3 | Inorganic Mixture 1 | 1064 | 2000 | 15 | 40 | 200 | 16 × 16 | | | | Included | 30 | 10/10 | 85 | 23 | 10/10 | 85 |
| Example 4 | Inorganic Mixture 1 | 1064 | 2000 | 12.5 | 40 | 200 | 16 × 16 | | | | Included | 28 | 10/10 | 85 | 20 | 10/10 | 80 |
| Example 5 | Inorganic Mixture 1 | 1064 | 2000 | 10.4 | 40 | 200 | 16 × 16 | | | | Included | 17 | 10/10 | 75 | 14 | 10/10 | 50 |
| Example 6 | Inorganic Mixture 1 | 1064 | 2000 | 20 | 60 | 200 | 16 × 16 | | | | Included | 34 | 10/10 | 90 | 26 | 10/10 | 88 |
| Example 7 | Inorganic Mixture 1 | 1064 | 2000 | 20 | 80 | 200 | 16 × 16 | | | | Included | 32 | 10/10 | 84 | 24 | 10/10 | 79 |
| Example 8 | Inorganic Mixture 1 | 1064 | 2000 | 20 | 60 | 250 | 16 × 16 | | | | Included | 35 | 10/10 | 90 | 26 | 10/10 | 88 |
| Example 9 | Inorganic Mixture 1 | 1064 | 2000 | 20 | 60 | 250 | 18 × 18 | | | | Included | 35 | 10/10 | 90 | 26 | 10/10 | 86 |
| Example 10 | Inorganic Mixture 1 | 1064 | 2000 | 20 | 40 | 100 | 10 × 10 | | | | Included | 32 | 10/10 | 75 | 21 | 10/10 | 73 |
| Example 11 | Inorganic Mixture 1 | 1064 | 1000 | 10.4 | 40 | 200 | 16 × 16 | | | | Included | 34 | 10/10 | 91 | 27 | 10/10 | 85 |
| Example 12 | Inorganic Mixture 1 | 1064 | 2000 | 20 | 40 | 200 | 16 × 16 | | | Included | Included | 35 | 10/10 | 90 | 27 | 10/10 | 88 |
| Example 13 | Inorganic Mixture 1 | 1064 | 2000 | 20 | 40 | 200 | 16 × 16 | | Included | | Included | 35 | 10/10 | 90 | 27 | 10/10 | 88 |
| Example 14 | Inorganic Mixture 1 | 1064 | 2000 | 20 | 40 | 200 | 16 × 16 | Included | | | Included | 35 | 10/10 | 90 | 27 | 10/10 | 88 |
| Example 15 | Inorganic Mixture 1 | 1064 | 2000 | 20 | 40 | 200 | 16 × 16 | Included | Included | Included | Included | 35 | 10/10 | 90 | 27 | 10/10 | 88 |
| Example 16 | Inorganic Mixture 2 | 1064 | 2000 | 20 | 40 | 200 | 16 × 16 | | | | Included | 35 | 10/10 | 90 | 27 | 10/10 | 88 |
| Example 17 | Inorganic Mixture 3 | 1064 | 2000 | 20 | 40 | 200 | 16 × 16 | | | | Included | 35 | 10/10 | 89 | 27 | 10/10 | 82 |
| Example 18 | Inorganic Mixture 1 | 355 | 500 | 2.5 | 40 | 200 | 16 × 16 | | | | Included | 21 | 10/10 | 62 | 13 | 10/10 | 55 |
| Example 19 | Inorganic Mixture 1 | 532 | 500 | 4 | 40 | 200 | 16 × 16 | | | | Included | 29 | 10/10 | 81 | 20 | 10/10 | 75 |
| Example 20 | Inorganic Mixture 1 | 1064 | 2000 | 8 | 40 | 200 | 16 × 16 | | | | Included | 9 | 7/10 | 15 | 6 | 2/10 | 10 |

As described above, even when the ceramic substrate was obtained by appropriately drawing the two-dimensional code in the green sheet and firing and dicing (dividing) the green sheet, the two-dimensional code was able to be read favorably.

That is, the result shows that, by appropriately drawing the two-dimensional code (or the barcode) in the green sheet, the ceramic substrate can be easily traced "from the beginning to the end" of the production of the ceramic substrate. As a result, more appropriate quality management or optimization of producing conditions can be easily performed through all the producing steps of the ceramic substrate.

Incidentally, it can be seen from comparison between Example 20 and other Examples that it is preferable to perform drawing with a laser having a high output to some extent to form cells having a depth of about 10 um or more from the viewpoint of further improving readability.

### REFERENCE SIGNS LIST

- 1:: green sheet (ceramic green sheet)
- 2:: substrate forming region
- 3:: outer peripheral region
- 5:: two-dimensional code

## Claims

1. A ceramic green sheet (1) comprising a plurality of substrate forming regions (2),
wherein a barcode or a two-dimensional code (5) being a QR code, a Data Matrix code or a PDF417 code is drawn in a portion of the ceramic green sheet (1), and
the barcode or the two-dimensional code (5) is obtained by encoding one or more of the following information (a) to (d),
(a) information relating to raw materials used when the ceramic green sheet (1) is produced,
(b) information relating to molding conditions of the ceramic green sheet (1),
(c) information relating to a release agent used when a plurality of the ceramic green sheets (1) are stacked, and
(d) a serial number.

2. The ceramic green sheet (1) according to claim 1,
wherein in the portion of the ceramic green sheet (1) where the barcode or the two-dimensional code (5) is drawn, a recess portion corresponding to a line of the barcode or a cell of the two-dimensional code (5) is present.

3. The ceramic green sheet (1) according to claim 2,
wherein a depth of the recess portion is 10 pm or more and 100 um or less.

4. The ceramic green sheet (1) according to any one of claims 1 to 3,
wherein the barcodes or the two-dimensional codes (5) are drawn in two or more of the plurality of substrate forming regions (2), respectively.

5. The ceramic green sheet (1) according to claim 4,
wherein the two or more barcodes or the two or more two-dimensional codes (5) are obtained by encoding different pieces of information.

6. The ceramic green sheet (1) according to any one of claims 1 to 3,
wherein the barcodes or the two-dimensional codes (5) are drawn in all of the plurality of substrate forming regions (2), respectively.

7. The ceramic green sheet (1) according to claim 6,
wherein all of the barcodes or the two-dimensional codes (5) are obtained by encoding different pieces of information.

8. The ceramic green sheet (1) according to any one of claims 1 to 7, comprising at least one selected from the group consisting of silicon nitride and aluminum nitride.

9. The ceramic green sheet (1) according to any one of claims 1 to 8, comprising a binder resin.

10. A method of producing a ceramic green sheet (1), the method comprising:
a preparation step of preparing a ceramic green sheet (1) including a plurality of substrate forming regions (2); and
a drawing step of irradiating a portion of the ceramic green sheet (1) with laser light to draw a barcode or a two-dimensional code (5) being a QR code, a Data Matrix code or a PDF417 code,
wherein the barcode or the two-dimensional code (5) is obtained by encoding one or more of the following information (a) to (d),
(a) information relating to raw materials used when the ceramic green sheet (1) is produced,
(b) information relating to molding conditions of the ceramic green sheet (1),
(c) information relating to a release agent used when a plurality of the ceramic green sheets (1) are stacked, and
(d) a serial number.

11. The method of producing a ceramic green sheet (1) according to claim 10,
wherein the laser light is infrared laser light.

12. A method of producing a ceramic substrate including a plurality of substrate forming regions (2), the method comprising a firing step of firing a ceramic green sheet (1) obtained using the method of producing a ceramic green sheet (1) according to claim 10 or 11.

## Patentansprüche

1. Keramische Grünfolie (1), die eine Vielzahl von substratbildenden Bereichen (2) umfasst,
wobei ein Strichcode oder ein zweidimensionaler Code (5), bei dem es sich um einen QR-Code, einen Data-Matrix-Code oder einen PDF417-Code handelt, in einen Abschnitt der keramischen Grünfolie (1) eingezeichnet ist, und
der Strichcode oder der zweidimensionale Code (5) durch Codieren einer oder mehrerer der folgenden Informationen (a) bis (d) erhalten wurde,
(a) Informationen über bei der Herstellung der keramischen Grünfolie (1) verwendete Rohstoffe,
(b) Informationen über Formungsbedingungen der keramischen Grünfolie (1),
(c) Informationen über ein bei der Stapelung einer Vielzahl der keramischen Grünfolien (1) verwendetes Trennmittel, und
(d) eine Seriennummer.

2. Keramische Grünfolie (1) nach Anspruch 1,
wobei in dem Abschnitt der keramischen Grünfolie (1), in dem der Strichcode oder der zweidimensionale Code (5) eingezeichnet ist, ein Vertiefungsabschnitt vorhanden ist, der einer Linie des Strichcodes oder einer Zelle des zweidimensionalen Codes (5) entspricht.

3. Keramische Grünfolie (1) nach Anspruch 2,
wobei eine Tiefe des Vertiefungsabschnitts 10 µm oder mehr und 100 um oder weniger beträgt.

4. Keramische Grünfolie (1) nach einem der Ansprüche 1 bis 3,
wobei die Strichcodes oder die zweidimensionalen Codes (5) jeweils in zwei oder mehr der Vielzahl der substratbildenden Bereiche (2) eingezeichnet sind.

5. Keramische Grünfolie (1) nach Anspruch 4,
wobei die zwei oder mehr Strichcodes oder die zwei oder mehr zweidimensionalen Codes (5) durch Codieren unterschiedlicher Informationen erhalten wurden.

6. Keramische Grünfolie (1) nach einem der Ansprüche 1 bis 3,
wobei die Strichcodes oder die zweidimensionalen Codes (5) jeweils in sämtliche der Vielzahl der substratbildenden Bereiche (2) eingezeichnet sind.

7. Keramische Grünfolie (1) nach Anspruch 6,
wobei sämtliche der Strichcodes oder der zweidimensionalen Codes (5) durch Codieren verschiedener Informationen erhalten wurden.

8. Keramische Grünfolie (1) nach einem der Ansprüche 1 bis 7, die mindestens eines aus der Gruppe bestehend aus Siliziumnitrid und Aluminiumnitrid enthält.

9. Keramische Grünfolie (1) nach einem der Ansprüche 1 bis 8, die ein Bindemittelharz enthält.

10. Verfahren zur Herstellung einer keramischen Grünfolie (1), wobei das Verfahren umfasst:
einen Herstellungsschritt zur Herstellung einer keramischen Grünfolie (1), die eine Vielzahl von substratbildenden Bereichen (2) aufweist; und
einen Zeichenschritt des Bestrahlens eines Abschnitts der keramische Grünfolie (1) mit Laserlicht, um einen Strichcode oder einen zweidimensionalen Code (5) einzuzeichnen, der ein QR-Code, ein Data-Matrix-Code oder ein PDF417-Code ist,
wobei der Strichcode oder der zweidimensionale Code (5) durch Codieren einer oder mehrerer der folgenden Informationen (a) bis (d) erhalten wird,
(a) Informationen über bei der Herstellung der keramischen Grünfolie (1) verwendete Rohstoffe,
(b) Informationen über Formungsbedingungen der keramischen Grünfolie (1),
(c) Informationen über ein bei der Stapelung einer Vielzahl der keramischen Grünfolien (1) verwendetes Trennmittel, und
(d) eine Seriennummer.

11. Verfahren zur Herstellung einer keramischen Grünfolie (1) nach Anspruch 10,
wobei das Laserlicht Infrarot-Laserlicht ist.

12. Verfahren zur Herstellung eines keramischen Substrats, das eine Vielzahl von substratbildenden Bereichen (2) umfasst, wobei das Verfahren einen Brennschritt des Brennens einer keramischen Grünfolie (1) umfasst, die unter Verwendung des Verfahrens zur Herstellung einer keramischen Grünfolie (1) nach Anspruch 10 oder 11 erhalten wurde.

## Revendications

1. Feuille de céramique crue (1), comprenant une pluralité de régions de formation de substrat (2),
dans laquelle un code-barres ou un code bidimensionnel (5), qui est un code QR, un code Data Matrix ou un code PDF417, est dessiné dans une partie de la feuille de céramique crue (1), et
le code-barres ou le code bidimensionnel (5) est obtenu en codant une ou plusieurs des informations suivantes (a) à (d),
(a) des informations relatives aux matières premières utilisées lors de la production de la feuille de céramique crue (1),
(b) des informations relatives aux conditions de moulage de la feuille de céramique crue (1),
(c) des informations relatives à un agent de démoulage utilisé lorsqu'une pluralité des feuilles de céramique crues (1) est empilée, et
(d) un numéro de série.

2. Feuille de céramique crue (1) selon la revendication 1,
dans laquelle, dans la partie de la feuille de céramique crue (1) où le code-barres ou le code bidimensionnel (5) est dessiné, une partie évidée correspondant à une ligne du code-barres ou à une cellule du code bidimensionnel (5) est présente.

3. Feuille de céramique crue (1) selon la revendication 2,
dans lequel une profondeur de la partie évidée est supérieure ou égale à 10 um et inférieure ou égale à 100 um.

4. Feuille de céramique crue (1) selon l'une des revendications 1 à 3,
dans laquelle les codes-barres ou les codes bidimensionnels (5) sont dessinés dans deux ou plusieurs de la pluralité de régions de formation de substrat (2), respectivement.

5. Feuille de céramique crue (1) selon la revendication 4,
dans laquelle les deux ou plusieurs codes-barres ou les deux ou plusieurs codes bidimensionnels (5) sont obtenus par codage d'éléments d'information différents.

6. Feuille de céramique crue (1) selon l'une des revendications 1 à 3,
dans laquelle les codes-barres ou les codes bidimensionnels (5) sont dessinés dans toutes les régions de la pluralité de régions de formation de substrat (2), respectivement.

7. Feuille de céramique crue (1) selon la revendication 6,
dans laquelle tous les codes-barres ou les codes bidimensionnels (5) sont obtenus en codant différents éléments d'information.

8. Feuille de céramique crue (1) selon l'une quelconque des revendications 1 à 7, comprenant au moins l'un choisi dans le groupe constitué par le nitrure de silicium et le nitrure d'aluminium.

9. Feuille de céramique crue (1) selon l'une quelconque des revendications 1 à 8, comprenant une résine liante.

10. Procédé de production d'une feuille de céramique crue (1), comprenant :
une étape de préparation pour préparer une feuille de céramique crue (1) comprenant une pluralité de régions de formation de substrat (2) ; et
une étape de dessin consistant à irradier une partie de la feuille de céramique crue (1) avec une lumière laser pour dessiner un code-barres ou un code bidimensionnel (5), qui est un code QR, un code Data Matrix ou un code PDF417,
dans lequel le code-barres ou le code bidimensionnel (5) est obtenu en codant une ou plusieurs des informations suivantes (a) à (d),
(a) des informations relatives aux matières premières utilisées lors de la production de la feuille de céramique crue (1),
(b) des informations relatives aux conditions de moulage de la feuille de céramique crue (1),
(c) des informations relatives à un agent de démoulage utilisé lorsqu'une pluralité des feuilles de céramique crues (1) est empilée, et
(d) un numéro de série.

11. Procédé de production d'une feuille de céramique crue (1) selon la revendication 10,
dans lequel la lumière laser est une lumière laser infrarouge.

12. Procédé de production d'un substrat céramique comprenant une pluralité de régions de formation de substrat (2), le procédé comprenant une étape de cuisson d'une feuille de céramique crue (1) obtenue en utilisant le procédé de production d'une feuille de céramique crue (1) selon la revendication 10 ou 11.
